# Europäisches Patentamt
## European Patent Office
### Office européen des brevets

(19)

(11) Publication number: **0 133 748**
**B1**

(12)

# EUROPEAN PATENT SPECIFICATION

(45) Date of publication of patent specification: **15.03.89**

(51) Int. Cl.⁴: **G 01 R 31/08**, G 01 M 3/18

(21) Application number: **84304502.2**

(22) Date of filing: **29.06.84**

(60) Divisional applications 87106434, 87106433 filed on 04.05.87.

(54) Method for detecting and obtaining information about changes in variables.

(30) Priority: **30.06.83 US 509897**
**11.04.84 US 599047**
**24.04.84 US 603485**
**07.06.84 US 618109**

(43) Date of publication of application:
**06.03.85 Bulletin 85/10**

(45) Publication of the grant of the patent:
**15.03.89 Bulletin 89/11**

(84) Designated Contracting States:
**AT BE CH DE FR GB IT LI LU NL SE**

(56) References cited:
**EP-A-0 028 142**
**AT-B- 58 704**
**DE-A-3 225 742**
**US-A-2 581 213**
**US-A-3 800 216**
**US-A-3 991 413**

(73) Proprietor: **RAYCHEM CORPORATION (a Delaware corporation)**
**300 Constitution Drive**
**Menlo Park, California 94025 (US)**

(72) Inventor: **Masia, Michael**
**258 Grand Street**
**Redwood City California 94062 (US)**
Inventor: **Reed, James Patrick**
**1745 Beach Street No. 10**
**San Francisco California, 94123 (US)**
Inventor: **Brooks, Peter Leonard**
**611 Glen Alto**
**Los Altos California 94022 (US)**
Inventor: **Tolles, Thomas Winton**
**3034 Jackson Street**
**San Francisco California 94115 (US)**
Inventor: **Reeder, Larry Russell**
**1182 Littleoak Drive**
**San Jose California 95129 (US)**

(74) Representative: **Jay, Anthony William et al**
**Raychem Limited Intellectual Property Law Department Faraday Road**
**Dorcan Swindon Wiltshire (GB)**

Courier Press, Leamington Spa, England.

## Description

This invention relates to methods and apparatus for detecting and obtaining information about (particularly locating) changes in variables.

A number of methods have been proposed for detecting and locating changes in variables along an elongate path, e.g. the occurrence of a leak (of water or another liquid or gas), insufficient or excessive pressure, too high or too low a temperature, the presence or absence of light or another form of electromagnetic radiation, or a change in the physical position of a movable member, e.g. a valve in a chemical process plant or a window in a building fitted with a burgular alarm system. Changes of this kind are referred to in this specification by the generic term "event". Reference may be made for example to US—A—1,084,910, 2,581,213, 3,248,646, 3,384,493, 3,800,216, and 3,991,413, GB—A—1,481,850 and DE—A—3,001,150.0 and 3,225,742. However, the known methods are expensive, and/or inaccurate, and/or cannot be used when the event causes electrical connection between two conductors through a connection which is of high or indeterminate resistance, e.g. an ionically conductive connecting element.

AT—A—58704 discloses a circuit arrangement for localizing faults in cables and wiring with the aid of a voltage drop method. On detecting a voltage drop along a length of wire, a voltmeter is adjusted by means of a variable resistor to calibrate the voltmeter. Subsequent voltage drops indicate the position of a fault.

Attention is also directed to Divisional Applications EP—A—0 250 776 (published 7.1.1988) and EP—A—0 253 085 (published 20.1.1988).

We have now discovered a simple and accurate method and apparatus for monitoring for the occurrence of an event, and for detecting and obtaining information about the event upon its occurrence (i.e. as soon as it occurs or at some time after it has occurred). In this method, upon occurrence of the event, at least one electrical connection is made between a source member and a locating member of known impedance characteristics, the connection or connections being effective at a first point at which the event takes place (or whose location is defined by some other characteristic of the event). A current of known size is then driven through the electrical connection(s) and down the locating member to a second point whose location is known. The voltage drop between the first and second points is then measured and the location of the first point can then be determined.

When the occurrence of the event causes a single or very short connection to be made between the locating member and the source member, then the "first point" will be easily identified, since it is the only connection point. However, when the event results in connection at two or more spaced-apart locations and/or over a finite length of the locating member, the "first point", i.e. the point whose location is determined from the measured voltage drop, is some intermediate point (which, if there are connections at two or more spaced-apart locations, may be at a location at which there is no connection between the locating and source members). It is for this reason that the connection to the locating member is referred to herein as being "effective" at the first point.

The invention overcomes one or more of the disadvantages of the known processes. For many uses, a particularly important advantage is that the information obtained can be independent of the impedance of the connection to the locating member, i.e. the information obtained remains the same even if a substantial and unknown change is made in the impedance of the connection.

In one aspect, the invention provides a method for monitoring for the occurrence of an event, and for locating the event upon its occurrence, which method comprises providing a system in which, upon occurrence of the event,

(1) electrical connection is made between an electrically conductive locating member and an electrically conductive source member generally coextensive with the locating member;

the locating member and/or the source member comprising a metal core and an elongate jacket which electrically surrounds the core and which is composed of a conductive polymer and which is event sensitive in such a manner as to allow said connection upon occurrence of an event;

the connection to the locating member being effective at a first point whose location is defined by at least one characteristic of the event;

the making of the connection enabling the formation of a test circuit which comprises (a) the source member, (b) the connection, (c) that part of the locating member which lies between the first point and a second point having a known location on the locating member, and (d) a power source which causes an electrical current of known size to be transmitted between the first and second points on the locating member; and the current and the locating member being such that, by measuring the voltage drop between the first and second points, the spatial relationship between the first and second points can be determined;

(2) the voltage drop between the first and second points is measured; and

(3) information concerning the event is obtained from the measurement made in step (2).

Preferably the voltage drop between the first and second points is determined by means of a voltage-measuring device which forms part of a reference circuit, the reference circuit comprising

(a) the voltage-measuring device,

(b) that part of the locating member which lies between the first and second points, and

(c) an electrically conductive return member having a first end which is electrically connected to one end of the locating member via the voltage measuring device and a second end which is electrically connected to the other end of the locating member, the return member being otherwise insulated from the locating member,

the voltage-measuring device having an impedance which is very high by comparison with any unknown part of the impedance of the other components of the reference circuit.

The invention also includes apparatus suitable for carrying out the method of the invention, in particular apparatus comprising

(1) an elongate electrically conductive locating member whose impedance from one end to any point on the locating member defines the spatial relationship between that end and that point;

(2) an elongate electrically conductive source member generally coextensive with the locating member; the locating member and/or the source member comprising a metal core and an elongate jacket which electrically surrounds the core and which is composed of a conductive polymer;

(3) an event-sensitive connection means which, upon occurrence of an event, effects electrical connection between the locating member and the source member, the connection being effective at a first point on the locating member which is defined by at least one characteristic of the event;

(4) a voltage-measuring device for determining the voltage drop between the first point and a second point which is at one end of the locating member;

(5) a power source which will furnish a current of known size, and which is electrically connected to the second point on the locating member and, in the absence of an event, is not otherwise connected to the locating member; and

(6) a return member having a first end which is electrically connected to one end of the locating member via the voltage-measuring device and a second end which is electrically connected to the other end of the locating member, the return member being otherwise insulated from the locating member;

whereby upon occurrence of an event which causes an electrical connection between the locating and source members, this enables the formation of the test circuit and a reference circuit which comprises the voltage-measuring device, the locating member, and the return member, the voltage-measuring device having an impedance which is very high by comparison with the impedance of the other components of the reference circuit.

The elongate member may and optionally also the source member may comprise:

(a) an elongate core which is composed of a metal whose temperatures coefficient of resistivity averages less than 0.003 per degree Centigrade over the temperature range 0° to 100°C and in which each longitudinal section has a resistance which is from $10^{-4}$ to $10^4$ ohms/foot $(3.3 \times 10^{-4}$—$3.3 \times 10^4$ ohm/m), and

(b) an elongate jacket which is composed of a conductive polymer which electrically surrounds the core, and in which each longitudinal section has a resistance which is at least 100 times the resistance of the core of that longitudinal section at all temperatures from 0°C to 100°C.

Brief description of the drawings

The invention is illustrated in the accompanying drawings, in which

Figure 1 is a generalised schematic circuit diagram of the method of the present invention.

Figures 2 to 28 are schematic circuit diagrams of the method and apparatus of the invention,

Figures 29—31 are graphs showing how the voltage drop between the first and second points on the locating member can vary in different systems of the invention, and

Figures 32 and 33 are diagrammatic cross-sections through apparatus of the invention.

Detailed description of the invention

In the interests of clarity, the following detailed description of the invention includes sections which are chiefly or exclusively concerned with a particular part of the invention. It is to be understood, however, that the relationship between different parts of the invention is of significant importance, and the following detailed description should be read in the light of that understanding. It should also be understood that, where features of the invention are described in the context of particular Figures of the drawing, the same description can also be applied to the invention in general and to the other Figures, insofar as the context permits.

1. The electrical characteristics of the invention

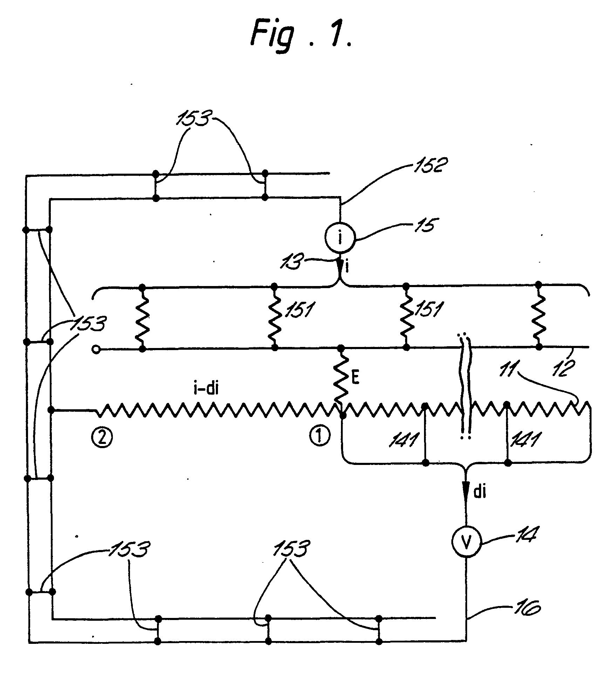

The basic electrical characteristics of the invention can best be understood by reference to Figure 1, which schematically represents a substantial number of the preferred methods and apparatus of the invention. In Figure 1, there is an elongate locating member 11, an elongate source member 12, a voltage-measuring device 14, a power source 15 and an elongate return member 16. The source member is electrically connected, through the power source, to one end of the locating member; in the absence of an event, there is no other electrical connection between the locating member and the source member. Between the source and locating members (but not shown in Figure 1) is an event-sensitive connection means (this term being used to include a continuous event-sensitive connection means and a plurality of spaced-apart event-sensitive connection means) which becomes conductive at any location at which an event takes place. In Figure 1, an event has taken place at a first point 1 which lies somewhere on the locating member, but whose location is otherwise unknown. As a result of the event, an electrical connection E has been made between the locating and source members. The power source 15 is connected via connection means 152 to the locating member at one end thereof, designated by the numeral 2, which is the "second point" in the definitions given above of the method and apparatus of the invention. (The second point could be at any point of known location between the end of locating member 11 and the connection point 1, providing that the voltage-measuring device is arranged to measure the voltage drop between the first and second points.) The power source is also connected to the source member by an auxiliary connection member 13; as schematically indicated by the plurality of connections 151, the connection between the power source and the source member can be made at any one or more points on the source member. Furthermore, these connections can be of any and unknown impedance, providing the power source can drive a known current between the first and second points of the locating member. Thus the making of the connection at point 1 results in the formation of a test circuit which includes the connection, the locating member between points 1 and 2, the power source 15, the auxiliary connection member 13, and (unless a single connection 151 is made between the power source and the source member at the connection point) part of the source member 12. As will be further discussed below, important advantages can be obtained if the only variable in the impedance of the test circuit is the impedance of the connection between the source and locating members. This result can be achieved by making use of a source member which has the same impedance characteristics as the locating member, and an auxiliary member which is connected to the source member only at the end thereof which is remote from point 2.

The voltage-measuring device is connected to the second point 2 on the locating member (via the return member 16) and is also connected to the locating member at one or more points whose distance from the second point is at least as far as the first point 1; as schematically indicated by the plurality of connections 141, these connections must be of known impedance or an impedance which is very small by comparison with the impedance of the voltage-measuring device. Thus the voltage-measuring device forms part of a reference circuit which comprises the device 14, at least that part of the locating member 11 between points 1 and 2, and the return member 16.

The power source 15 and the voltage-measuring device 14 can be connected to the point 2 on the locating member 11 in any convenient way. Thus, as indicated by the plurality of connections 153, the connection member 152 and the return member 16 can be connected to each other at any one or more locations.

It will be seen that the location of point 1 can be calculated if the following are known:—

(a) the current flowing between points 1 and 2,
(b) the impedance of the components of the reference circuit,
(c) the voltage drop measured by the voltage-measuring device,
(d) the location of point 2, and

(e) the impedance of the locating member between point 2 and each point on the locating member.

Systems in which these features are known can be provided in a number of different ways. The accuracy with which the first point can be located is limited by the ratio of the impedance of the voltage-measuring device to any unknown part of the impedance of the other components of the reference circuit, and in most cases it is convenient to use components such that the ratio of the impedance of the device to the total impedance of the rest of the reference circuit is very high. Accordingly, these ratios should preferably be at least 100, particularly at least 1,000, especially at least 10,000. It is for these reasons that the connections 141 and 153 in Figure 1 are shown as having low resistance. By contrast, the impedance of the connection between the locating and source members, and the impedance of the other components of the test circuit, do not affect the accuracy of the information obtained; this is an important advantage of the invention.

2. Information which can be provided about an event

The method of the invention not only detects that a particular event has taken place, but also provides information about its location, particularly when the event takes place at (or near) the location of the first point. Other information can however be provided; for example when the temperature at a particular location is being monitored, one point on the locating member can be identified when the temperature is in one temperature range and another point can be identified when the temperature is in a different temperature range. The method can, for example, usefully be employed to determine that a given event (e.g. the opening of a valve) has taken place at one or more of a relatively small number of different locations, out of a relatively large number of possible locations for the event, leaving it to visual inspection or some other form of test (which may be a further and different method of the invention) to determine precisely where the event has taken place.

3. Event which can be detected, and event-sensitive connection means for detecting them

The event which is detected in the method of the invention can be an event which is not desired (a fault) or an event which is desired. The event can be the existence of a particular condition or a change in a single variable, e.g. an increase in pressure above a particular value, or a simultaneous or sequential change in two or more variables, e.g. an increase in pressure accompanied by an increase in temperature. The event can be a change in a variable which lasts for only a very short time, or a change in a variable which is maintained for some minimum time. The event can be of any kind which directly or indirectly permits or causes the current to be transmitted between the first point and the second point on the locating member. As noted above, the information obtained is independent of the impedance of the connection. Thus the connection between the locating and source members can be of any kind, for example an electronic connection (which can be of substantially zero impedance or can have substantial impedance), or an ionic connection resulting from the presence of an electrolyte, or an inductive connection. The change which takes place in order to effect the connection between the locating and source conductors is preferably a reversible change. However, the invention is also useful when the change is a permanent one, so that the apparatus must be replaced or repaired before the system is operational again. The system can be arranged so that it signals an event only while the event is taking place or so that it signals that an event has occurred in the past; in the latter case, the system will normally be arranged so that it can be reset.

Examples of events which can be detected include, but are not limited to, the following.

A. The presence of water or another electrolyte which provides an ionic connection between exposed surfaces of the locating and source members. In this case, the event-sensitive connection means can be merely a space between the locating and source members, or it can be a connection member on which the electrolyte collects or which absorbs the electrolyte.

B. The existence of a temperature which is below a first temperature $T_1$ or above a second temperature $T_2$. In one apparatus for detecting such a condition, the locating and source members are physically contacted by a connecting member which insulates them from each other at $T_1$ and connects them to each other at $T_2$. For example, at least part of the connecting member can comprise (a) a first material and (b) a second material which is dispersed in the first material and which forms mobile ionic species when the temperature changes from $T_1$ to $T_2$. Thus the first material can be one which changes phase, e.g. melts, when the temperature changes from $T_1$ to $T_2$.

In another apparatus for detecting a temperature change, the locating and source members are separated from each other by a deformable insulating medium, e.g. an insulating medium which is at least in part a fluid, e.g. air, and the apparatus comprises a connecting member which changes shape when the temperature change from $T_1$ to $T_2$, thus forcing the members into contact, by deforming the insulating medium, or, if the connecting member is itself conductive, by forcing the connecting member through the insulating medium to connect the members. The connecting member can comprise a heat-recoverable polymer or a heat-recoverable memory metal or can comprise a bimetallic strip. The term "memory metal" is used herein to denote one of the metal alloys (in particular various brass alloys and nickel-titanium alloys) which exist in a strong austenitic state about a transformation temperature and in a weak martensitic state below that transformation temperature, and which, if fabricated in a first shape in the austenitic state, can be cooled to the martensitic state and then deformed, will retain the deformed configuration until reheated to the austenitic state, when they will revert (or attempt to revert) towards the original shape. Where a reversible effect is desired, a particular type of memory metal must be employed or the memory metal member can be combined with a conventional spring metal member to produce a connecting member which will connect the locating and source members either when the temperature rises above the transformation temperature or when it falls below the transformation temperature (as more specifically discussed below, in connection with the Figures). For further detail of memory metals and devices comprising them reference may be made for example to US—A—3,174,851, 3,740,839, 3,753,700, 4,036,669, 4,144,104, 4,146,392, 4,166,739 and 4,337,090.

C. A change in the concentration of a particular substance, which may for example be a gas a liquid or a solid dispersed in a gas or a liquid, the locating and source members being physically contacted by a connecting member which insulates them prior to said change, and which electrically connects them as a result of said change. The electrical connection can for example result from a chemical reaction between the substance and at least part of the connecting member, thus for example releasing a mobile ionic species. Alternatively, the presence of the substance can for example cause at least part of the connecting member to change shape, as for example where the substance causes swelling of a conductive polymer connecting member or where the substance is a solvent for an adhesive or polymeric retaining member which maintains a spring member in a deformed state, or can change the state of an ionization chamber, for example in a smoke detector, or the transmissivity of a photoelectric cell, which in turn will cause a switch to connect the locating and return members.

D. A change from a first pressure $P_1$, to a second pressure, $P_2$, the locating and source members being contacted by a connecting member which insulates them from each other at pressure $P_1$ but permits electrical connection between them at pressure $P_2$. For example, the connecting member can be deformable, e.g. composed of air or other fluid insulating material.

E. A change in the intensity or other characteristic of electromagnetic radiation, the locating and source members being physically contacted by a connecting member which is exposed to said radiation, which insulates them from each other prior to said change and which electrically connects them to each other after said change. Suitable apparatus could for example include a photoelectric cell.

F. A change in the position of a valve, e.g. in a refinery or other chemical process plant, thus changing the position of a switch in a connecting member between the locating and source members.

**(4) Setting a maximum for the impedance of the connection between the source and locating members**

In some situations, it is desirable that the system should not signal an event when the connection between the source and locating members has an impedance over some preselected value, for example when the presence of a small amount of electrolyte makes a very high resistance connection. In these situations, the system is preferably such that when the current in the test circuit is below a preselected value, the occurrence of an event is not signalled.

This is particularly important when, as is preferred, the power source is a fixed current source, since the voltmeter may otherwise provide a false indication of the location of the event. This is because the fixed current source will only provide the expected fixed current if the compliance voltage of the power source is high enough to drive the fixed current through the test circuit. Therefore, if the impedance of the test circuit is too high, the actual current in the test circuit will be less than the "fixed" current, and the voltage drop between the first and second points on the locating member will not correctly represent the location of the first point. This difficulty can be avoided by blanking out the display on (or associated with) the voltmeter if the current is below the fixed value or by including in the test circuit a current switch which will prevent currents below the "fixed" current from flowing in the test circuit.

Even when the information provided about the event is correct, delivery of that information may be undesirable. Under these circumstances, when using a constant current source, the output voltage of the source can be monitored, and delivery of information prevented unless the output voltage is within a predetermined range. Similarly, when using a constant voltage source, the current in the test circuit can be monitored, and delivery of information prevented (for example by use of a current switch or by blanking out the display on, or associated with, the voltmeter) unless the current is within a predetermined range.

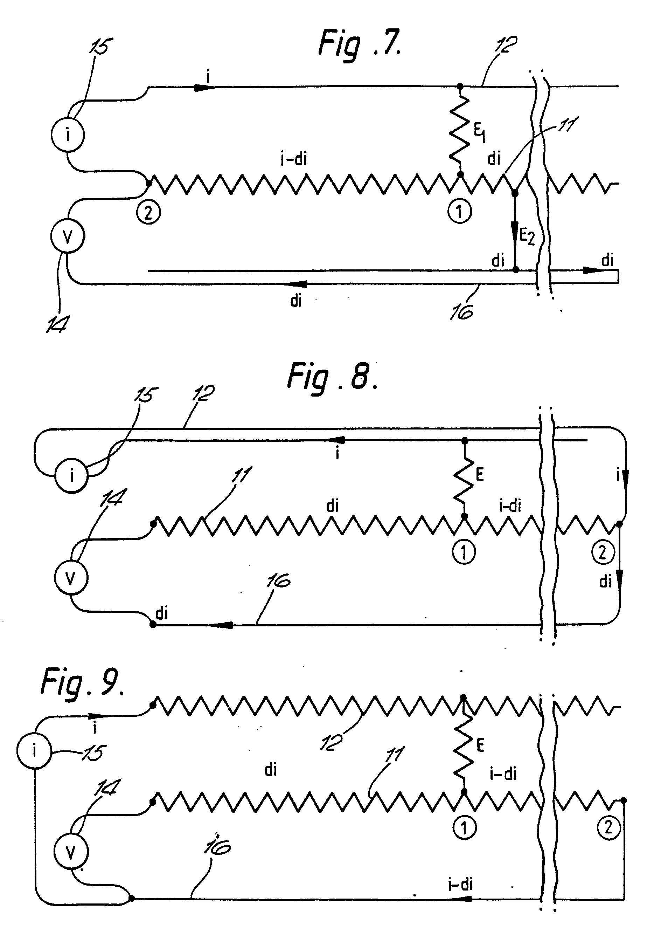

In a system of this kind, the critical parameter (in determining whether or not the information is delivered) is the impedance of the test circuit, and it is, therefore, desirable that the only variable impedance in the test circuit should be the impedance of the connection. This can be achieved by including in the test circuit a component which (1) is connected in series with that part of the locating member which lies between the first and second points, and (2) has an impedance substantially equal to the difference between the total impedance of the locating member and the impedance of that part of the locating member which lies between the first and second point. Such a component is preferably provided by making use of a source member which has the same impedance characteristics as the locating member, and by ensuring that the test circuit includes complementary portions of the source and locating members which, taken together, have the same impedance wherever the connection is made. This can be done by making the return member form part of the test circuit (as shown in Figure 9), or by including an auxiliary member which is connected to the end of the source member which is remote from the second point. If such a component is present, the sensitivity of the system will be the same throughout its length. In the absence of such a component, the impedance of the locating member (between the first and second points) will also be a variable, and it will not be possible to fix precisely the range of impedances of the connection which will cause an event to be signalled. When no such component is present, the limiting value or values of the impedance of the connection should preferably be at least 2 times, particularly at least 5 times, especially at least 10 times, the impedance of the full length of the locating member.

The sensitivity of such systems can easily be changed (for example so that leaks of different minimum sizes are signalled). When using a fixed current source, sensitivity can be changed by changing the compliance voltage of the source and/or by including a known impedance in the test circuit, and/or by changing the preselected range of output voltages. When using a fixed voltage source, the size of the voltage can be changed, and/or a known impedance can be included in the test circuit, and/or the preselected current value can be changed.

The method of the invention may employ apparatus which is suitable for connection to locating, source and return members in order to provide a system in which information is reported only when V/I is within a predetermined range, the apparatus comprising

(1) a first terminal;
(2) a second terminal;
(3) a third terminal;
(4) means for connecting the first and second terminals to a power source;
(5) a voltage-measuring device for measuring the voltage drop between the second and third terminals;
(6) a display unit for displaying information derived from a voltage drop measured by the voltage-measuring device; and
(7) a device which, when the first and second terminals are connected to a power source and are connected to each other through a locating member and a source member, thus forming a test circuit, prevents the display unit from displaying information if the value of the ratio V/I is outside a predetermined range, where I is the current in the test circuit in amps and V is the output voltage of the power source in volts.

This apparatus will often comprise a support member to which components (1) to (7) are attached, and/or a housing which provides physical and/or electrical protection for the components.

(5) Measuring the voltage drop down the locating members with the aid of a reference impedance

When a "fixed" current source is used to provide a very low current, the current may vary substantially (e.g. by about 4%) from the "fixed" value (even when the output voltage is less than the compliance voltage). Other factors may also cause the current in the test circuit to vary with time. Under these circumstances, preferably the test circuit includes a reference impedance which is connected in series with the locating member, and the location of the first point is calculated from the ratio of the voltage drop between the first and second points to the voltage drop over the reference impedance. In effect, this procedure measures the current in the test circuit by measuring the voltage drop over the reference impedance.

(6) The locating member

The locating member is preferably an elongate member, this term being used to denote a member having a length which is substantially greater, e.g. at least 100 times greater, often at least 1,000 times greater, sometimes at least 10,000 times greater or even at least 100,000 times greater, than either of its other dimensions. However, the locating member can also be in the form of a sheet or some other more complex shape.

The locating member preferably has sufficient impedance to cause a voltage drop which is easily and accurately measured. Preferably, therefore, it has a resistance which averages at least 0.1 ohm/ft (0.33 ohm/m) particularly at least 1 ohm/ft (3.3 ohm/m), e.g. 1 to 5 ohm/foot (3.3 to 16.5 ohm/m). On the other hand its resistance should preferably not be too high and it preferably averages less than $10^4$ ohm/foot ($3.3 \times 10^4$ ohm/m), especially less than 20 ohm/foot (95.5 ohm/m). A key feature of the present invention is that, under the conditions of operation, the impedance of the locating member is dependent substantially only on the distance between the first and second points. This is essential because it is not otherwise possible to calculate the location of the first point from the change in voltage measured by the voltage-measuring device. The locationg member may be of constant cross-section along its length so that its resistance per unit length is constant and the voltage change is directly proportional to the distance between the first and second points. However, this is not essential, providing that the impedance changes in a known fashion along the length of the member, so that the voltage change and the distance can be correlated. Thus under some circumstances, considerable advantages may result from the use of a locating member which comprises a plurality of spaced-apart impedances which are connected by intermediate elongate components of low impedance.

The most common variable affecting the resistivity (and, therefore, resistance) of the locating member is temperature. Many materials, and in particular copper and other metals most commonly used for electrical conductors, have a resistivity which changes with temperature to an extent which, although unimportant for many purposes, can result in unacceptable margins of error in locating the first point under conditions in which the temperature can vary substantially and unpredictably along the length of the locating member. It is preferred, therefore, that the locating member should have a temperature coefficient of impedance (usually resistance) which averages less than 0.003, particularly less than 0.0003, especially less than 0.00003, per degree Centigrade over at least one 25° temperature range between −100°C and 1500°C, and preferably over the temperature range 0° to 100°C, especially over the temperature range 0° to 200°C. For a simple metal conductor, the temperature coefficient of impedance is the same as the temperature coefficient of resistivity. The value for copper is about 0.007 per deg C. Metals having lower temperature coefficients of resistivity are well known and include Constantan (also known as Eureka), Manganin and Copel, and others listed for example in the International Critical Tables, published 1929 by McGraw-Hill Book, Co., Vol. VI, pages 156—170.

It is of course important that the locating, source and return members should be sufficiently strong, and should be assembled in such a way, that they can withstand the stresses on them during installation and use. For the return member this usually presents no problem, because it can be and preferably is securely enclosed in a conventional polymeric insulating jacket. However, electrical contact is necessary at intermediate points of the locating and source members, and can be necessary at intermediate points of the return member also. This could result in problems, if one or more of the members were merely a wire of relatively small cross-section. However, we have found, especially where the event in the presence of an electrolyte, an excellent combination of desired properties can be obtained by the invention through the use of a locating member and/or a source member comprising a metal core and an elongate jacket which electrically surrounds the core and which is composed of a conductive polymer. The term "electrically surrounds" is used herein to mean that all electrical paths to the core (intermediate the ends thereof) pass through the jacket. Normally the conductive polymer will completely surround the core, being applied for example by a melt-extrusion process; however it is also possible to make use of a jacket which has alternate insulating sections and conductive sections.

The term "conductive polymer" is used herein to denote a composition which comprises a polymeric component (e.g. a thermoplastic or an elastomer or a mixture of two or more such polymers) and, dispersed in the polymeric component, a particulate conductive filler (e.g. carbon black, graphite, a metal powder or two or more of these). Conductive polymers are well known and are described, together with a variety of uses for them, in for example US—A—2,952,761, 2,978,665, 3,243,753, 3,351,882, 3,571,777, 3,757,086, 3,793,716, 3,823,217, 3,858,144, 3,861,029, 4,017,715, 4,072,848, 4,117,312, 4,177,446, 4,188,276, 4,237,441, 4,242,573, 4,246,468, 4,250,400, 4,255,698, 4,271,350, 4,272,471, 4,304,987, 4,309,596, 4,309,597, 4,314,230, 4,315,237, 4,317,027, 4,318,881 and 4,330,704; J. Applied Polymer Science *19* 813—815 (1975) Klason and Kubat; Polymer Engineering and Science *18*, 649—653 (1978), Narkis et al; DE—A—2,634,999; 2,755,077; 2,746,602; 2,755,076; 2,821,799; EP—A—38,718; 38,715 38,713; 38,714; 38,716; GB—A—2,076,106; and 2062246, 2096393, 2100959, 2100290, 2106920, 2118810 and 2120909.

The resistivity of conductive polymers usually changes with temperature at a rate well above the preferred temperature coefficient of resistivity set out above, and the PTC conductive polymers often increase in resistivity by a factor of 10 or more over a 100°C range. Accordingly it is important that in a locating member comprising a conductive polymer jacket, at all temperatures likely to be encountered, e.g. at all temperatures from 0° to 100°C, each longitudinal section of the conductive polymer jacket has a resistance which is at least 100 times, preferably at least 1000 times, the resistance of the core of that longitudinal section. In this way (since the core and the jacket are connected in parallel), the jacket does not make any substantial contribution to the resistance of the elongate conductor, and any change in its resistance with temperature is unimportant.

The second point on the locating member must have a known location, and it is normally a fixed point. When the system is designed to detect different types of events occurring independently, the second point is preferably the same fixed point for detection of the different events. In the case of an elongate locating member, the second point will normally be at one end or the other of the locating member. However, the invention includes, for example, the simultaneous or sequential use of a plurality of second points to determine the locations of a plurality of first points when a number of different events having identified a number of first points.

(7) The source member

The source member preferably has the same general configuration and follows the same general path as the locating member. Thus it is preferred that the locating and source members are elongate members which follow the same elongate path, often (but by no means necessarily) parallel to each other. If the adjacent ends of the source and locating members are connected to each other (through the power source), then a wide variety of elongate electrical connection members will provide the necessary connection to the event-sensitive connection means and, where appropriate, also provide the event-sensitive connection means. Thus the source member can be the same as, or different from, the locating member. The disclosure in Section 6 above about conductive polymers is also applicable to the source member. The source member preferably has substantially no reactance. In order to reduce the input voltage required to provide a controlled current in the test circuit, the source member can have a lower resistance per unit length than the locating member.

When the source and locating members are connected so as to provide a test circuit in which the only variable impedance is the connection between the source and locating members caused by the event, then the source member is preferably substantially identical to the locating member.

(8) The return member

In many cases, the return member also has the same general configuration and follows the same general path as the locating member. This is preferred when the return member is electrically connected to the locating member at the ends thereof but is otherwise insulated therefrom. On the other hand it is not necessary when the locating and source members follow a path in the form of a loop, since the return member can then be a relatively short member which joins (*via* the voltage-measuring device) the two ends of the locating member. The return member will usually follow the same general path as the source and locating members in another embodiment in which, when an event occurs, not only is a connection made between the locating and source members, but also an electrical connection of known resistance is made between the return member and the locating member at the first point or at some other point on the locating member which is further away from the second point. The return member preferably has substantially no reactance and can conveniently be a simple insulated wire whose resistance per unit length is sufficiently low for the resistance of the return member to be ignored in obtaining the desired information about the event, e.g. less than 0.01 times the resistance per unit length of the locating member.

(9) Assembly of the elongate connection members

The source and locating members, usually the return member, the auxiliary member when present, and any other elongate members which may be desired (e.g. for checking continuity or to provide physical strength) can be combined together in any convenient way to provide a cable which can be positioned along the desired elongate path. If desired the return member, or the locating member, or a further member can be relatively large and strong, and thus be a strength member to which the other members are secured, e.g. by wrapping, preferably in the form of a braid which may include additional elongate members.

**(10)  Use of substantially identical locating and source members**

Very valuable improvements can be obtained through the use of a locating member which has impedance characteristics such that, and which is connected so that, the only variable impedance in the test circuit is the impedance of the connection which is created by the occurrence of the event. As noted above, this makes it possible to design a system which, at all points along its length, will be sensitive only to events which create a connection whose impedance is within a predetermined range. Another important advantage is that the impedance of the connection itself can be measured. This can be done, for example,

(a) when a constant current source is used, by measuring the output voltage;

(b) when a constant voltage source is used, by measuring the current in the test circuit; or

(c) by including a switching arrangement so that, after the location of the event has been determined, a new circuit is created in which the voltage measured by the voltmeter is a measure of the impedance of the event.

When the locating member is of the kind in which the locating member includes a plurality of spaced-apart impedant components, the source member preferably comprises corresponding spaced-apart impedant components. In order to make up such a system it is convenient to use preassembled modules which can be connected into the locating and source members to provide impedant components in those members and an event-sensitive connection member to connect those members when an event takes place. Such modules are novel. Thus, an event-sensitive module may be used which is suitable for use in a method for detecting and obtaining information about an event, and which comprises

(1) a first impedant component having substantial impedance;

(2) a first conductor which has a relatively very small impedance and one end of which is connected to the first impedant component;

(3) a second impedant component having the same impedance as the first impedant component;

(4) a second conductor which has a relatively very small impedance and one end of which is connected to the second impedant component;

the first impedant component and the first conductor on the one hand and/or the second impedant component and the second conductor on the other hand comprising a metal core and an elongate jacket which electrically surrounds the core and which is composed of a conductor polymer; and

the first impedant component and the first conductor, in the absence of an event, being electrically insulated from the second conductor and the second impedant component; and

(5) an event-sensitive connection means which upon occurrence of an event, can effect electrical connection between the first and second conductors;

The first impedant component and the first conductor being connectable in series with incoming and outgoing portion of an elongate electrically conductive locating member, and the second impedant component and the second conductor being connectable in series with incoming and outgoing portions of an elongate electrically conductive source member. Preferably the module also comprises a third impedant component connected to the other end of the first conductor, and a fourth impedant component connected to the other end of the second conductor, the third and fourth components having the same impedance as the first and second components. When using such a preferred module it does not matter whether the incoming portion of the locating member is connected to the first component and the outgoing portion of the locating member is connected to the third component, or vice versa. Similarly it does not matter whether the incoming portion of the source member is connected to the second component and the outgoing portion of the source member is connected to the fourth component, or vice versa. This reduces the danger of incorrect installation of the system. Indeed, if the event-sensitive connection means operates in the same way whichever the direction of the current through it, it does not matter how the intermediate portions of the source and locating members are connected to the module, provided that the locating member is connected through one of the conductors and the source member is connected through the other conductor.

The module will often comprise a support member to which components (1) to (5) are secured; and/or a housing which provides physical and/or electrical protection for the components; and/or terminals for connecting the module as indicated above.

**(11)  The power supply**

The current which is transmitted between the first and second points must be of known size, and is preferably supplied by a controlled current source, e.g. a galvanostat; however, a controlled voltage source can be used providing that a current-measuring device is included in the apparatus so that the location of the first point can be calculated. In either case, there is provided a power source which causes an electrical current of known size to be transmitted. The current may be a continuous or pulsed direct current or an alternating current of regular sinusoidal or other form. The current which flows between the first and second points is often in the range of 0.05 to 100 milliamps, particularly 0.1 to 10 milliamps, e.g. 0.5 to 3 milliamps. However, where very long paths are to be monitored for events, even lower currents can be employed, especially when using a reference impedance. The controlled current source is preferably a fixed current source or a current source which can be adjusted to provide current of a desired and known value, for example to obtain improved accuracy in locating a fault which was detected at a lower current level. However, it is also possible to use a fixed voltage source, in combination with a current-measuring device which measures the current flowing between the first and second points. The power source is preferably connected to the locating member at the second point at all times and, in the absence of an event, is otherwise insulated from the locating member.

(12) The voltage-measuring device

The voltage-measuring device can be of any kind, and suitable devices are well known to those skilled in the art. Preferably the voltage-measuring device is a voltmeter which has a resistance of at least 10,000 ohms, preferably at least 1 megohm, especially at least 10 megohms.

(13) Physical and electrical relationships between the components of the apparatus

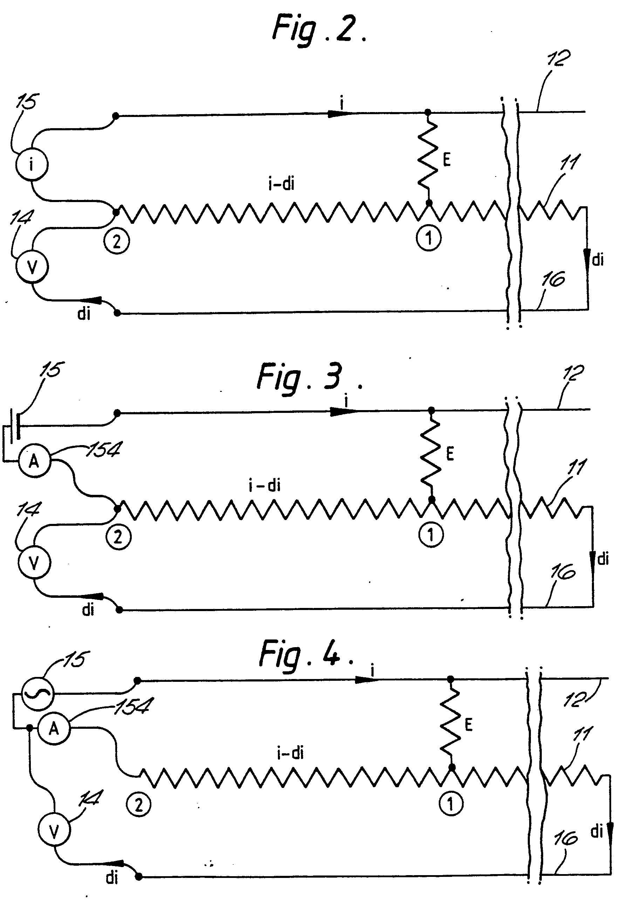

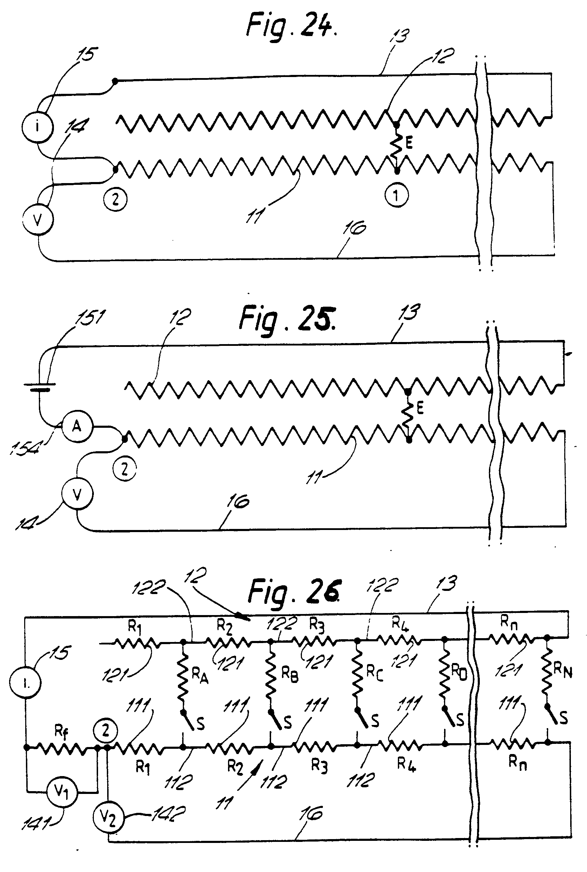

As briefly indicated in the description of Figure 1, the physical and electrical relationships between the components of the apparatus of the invention can be widely varied. Figures 2—23 show a number of different arrangements which are specific examples of the circuit generically illustrated in Figure 1 and of various preferred embodiments of the invention. In each of Figures 2—23, there is a power source 15, a voltage-measuring device 14, a locating member 11, a source member 12 and a return member 16. The locating member is shown as a resistor because it must have appreciable resistance in order for the voltage drop down it to be large enough to permit accurate location of the point 1, at which the source member is connected to the locating member. The source member is shown as a simple low resistance conductor in some Figures and as a resistive member identical to the locating member in other Figures. The return member is shown as a simple low resistance conductor, which it preferably is, but the return member can have substantial resistance, providing that it is a known resistance. The connections E, $E_1$, $E_2$ and $E_3$, are shown as resistors if they form part of the test circuit, since the invention permits these connections to be of indeterminate and high resistance (though of course they can be of substantially zero resistance or of substantial and known resistance). On the other hand, these connections are shown as simple conductors if they form part of the reference circuit, since the invention requires that these connections are of known, and preferably small, resistance. In a number of the Figures, there are shown switches, S, $S_1$ and $S_2$. Any other means can be employed, in addition to simple switches making a zero resistance electronic contact, in the test circuit, and any other means providing a connection of known resistance can be used in the reference circuit. In most of Figures 2—28, the power source is shown as a controlled current source, but in Figures 3 and 25, the power source is a battery and the test circuit includes an ammeter 154; and in Figure 4 the power source is a controlled voltage AC source and the test circuit again includes an ammeter 154.

Some of the different possible relationships between the components will now be enumerated, using Figures 2—28 as examples of these relationships.

(A) The power source can be positioned near the second point on the locating member, as illustrated in Figures 2—7 and 12—28, or near the end of the locating member which is remote from the second point, as illustrated in Figures 8—9. In most cases, the power source and the voltage-measuring device are positioned near to each other as illustrated in Figures 2—5 and 7—28.

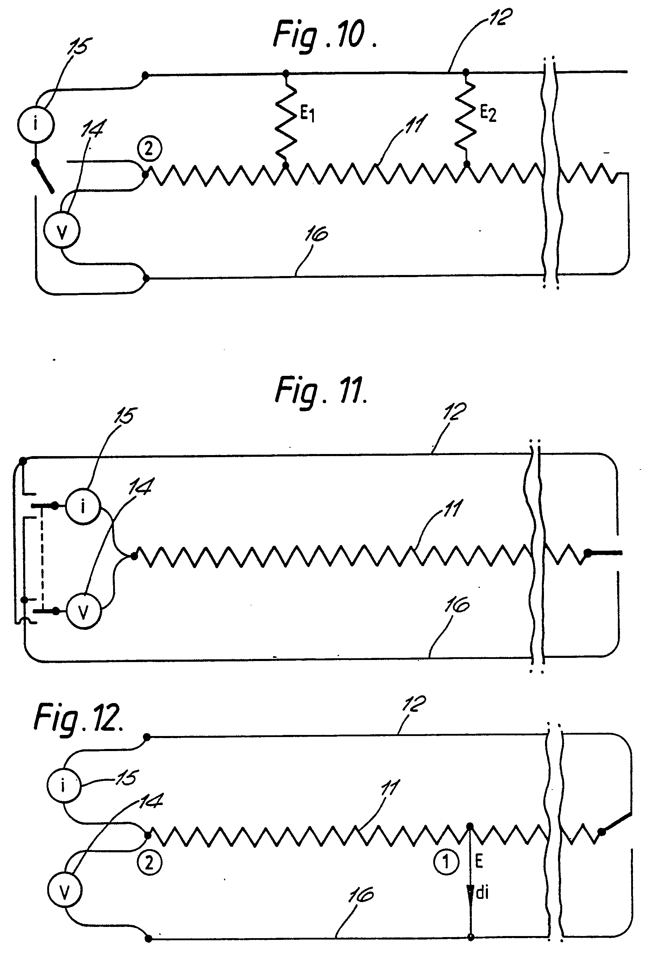

(B) As shown for example in Figure 10, the apparatus can include one or more switches, which may be ganged together or may operate independently, to provide for switching the connections between the locating member and the power source from a first arrangement in which the second point is at one end of the locating member as shown in Figure 2, to a second arrangement in which the second point is at the opposite end of the locating member, as shown in Figure 9, thus making it possible first to measure the distance from one end that an event has taken place and then to measure the distance from the other end that an event has taken place.

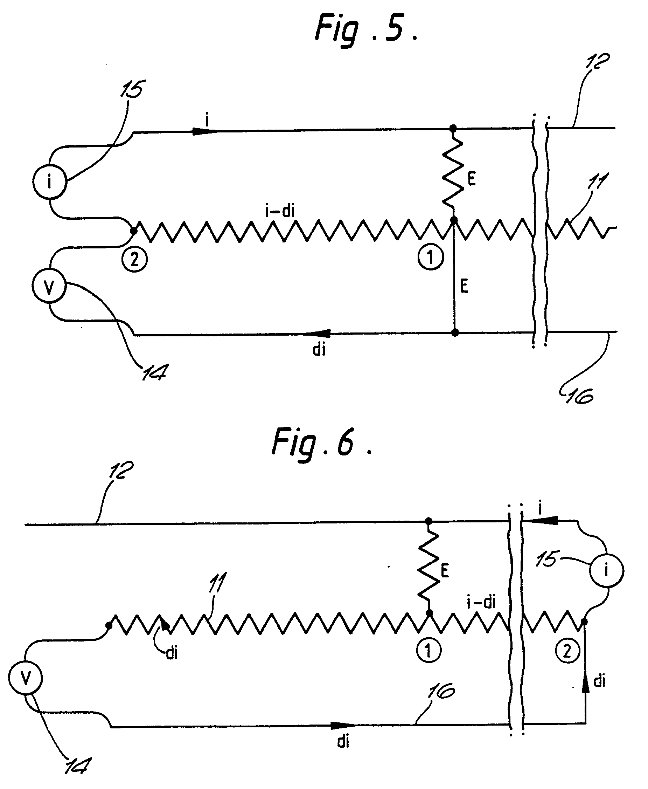

(C) It is also possible for the apparatus to be one in which occurrence of the event causes not only connection between the source and locating members, but also connection between the return and locating members, as shown for example in Figures 5, 7, 19 and 20. Such a system can be valuable for example in providing a cut-to-length apparatus. The making of the connection between the locating and return members can be the direct result of the making of the connection between the locating and source members, e.g. by means of a ganged switch, or the condition which causes one connection to be made can also cause the other connection to be made. These two possibilities are shown in Figure 5. Alternatively, the connection between the locating and return members can result from the existence of a condition which is different from the condition which effects connection between the locating and source members. This possibility is shown in Figures 7, 19 and 20.

(D) It is also possible, as shown for example in Figure 11, for the apparatus to include one or more switches, which may be ganged together or may operate separately, so that the apparatus can be converted into an electrical system as illustrated in Figure 12, in which

(a) an electrical current is driven down the whole length of the locating member by the power source,

(b) the return member is electrically connected to the second point on the locating member through the voltage-measuring device, and is otherwise insulated from the locating member, and

(c) when a second and different type of event occurs, a connection of known impedance is made between the locating member and the return member, thus creating a reference circuit which comprises a voltage-measuring device, those parts of the locating member and return member which lie between the first and second points, and the connection of known impedance, the voltage-measuring device having a known impedance which is very high by comparison with any unknown part of the impedance of the other components of the reference circuit.

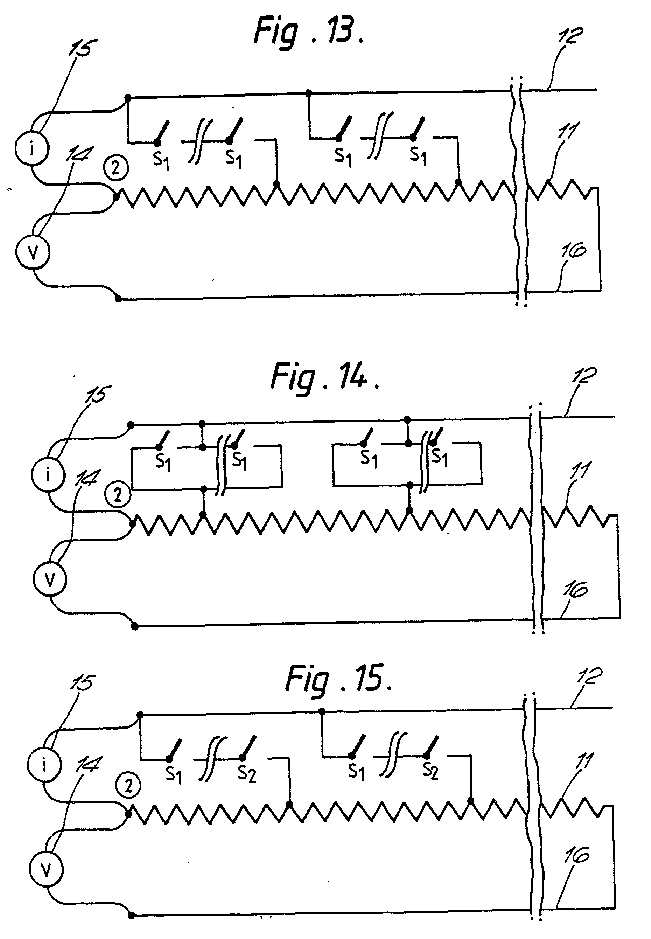

(E) As shown for example in Figure 13, the event can comprise the existence of a particular condition at each of a plurality of spaced-apart locations, the connection between the locating member and the source member being made through an event-sensitive connection member comprising a plurality of condition-sensitive members which are electrically connected in series, which are respectively located at each of said spaced-apart locations, and each of which is electrically conductive when said condition exists at its location and is not electrically conductive when said condition does not exist at its location.

(F) As shown for example in Figure 14, the event can comprise the existence of a particular condition at least one of a plurality of spaced-apart locations, the connection between the locating member and the source member being made through an event-sensitive connection member comprising a plurality of condition-sensitive members which are electrically connected in parallel, which are respectively located at each of said spaced-apart locations, and each of which is electrically conductive when said condition exists at its location and is not electrically conductive when said condition does not exist at its location.

(G) As shown for example in Figure 15, the event can comprise the existence of a first condition at a first location and the existence of a second condition at a second location (which may be immediately adjacent the first location), the connection between the locating member and the source member being made through an event-sensitive member comprising (a) a first-condition-sensitive member which is at the first location and which is electrically conductive when the first condition exists at the first location and is not electrically conductive when the first condition does not exist at the first location and (b) a second-condition-sensitive member which is at the second location, which is electrically conductive when the second condition exists at the second location and is not electrically conductive when the second condition does not exist at the second location, and which is electrically connected in series with the first-condition-sensitive member.

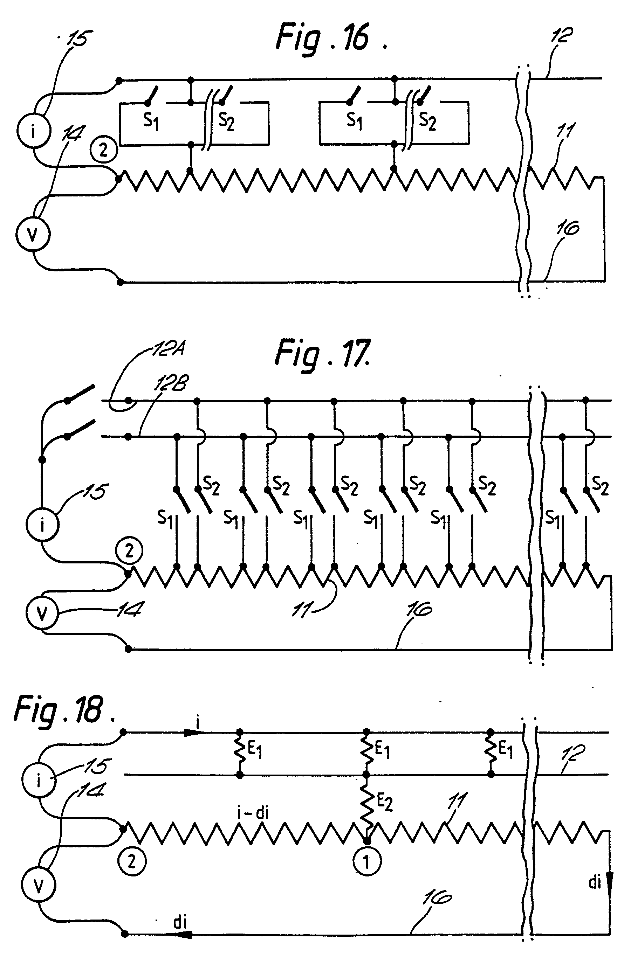

(H) As shown for example in Figure 16, the event can comprise the existence of a first condition at a first location or the existence of a second condition at a second location, (which may be immediately adjacent the first location), the connection between the locating member and the source member being made through an event-sensitive member comprising (a) a first-condition-sensitive member which is at the first location and which is electrically conductive when the first condition exists at the first location and is not electrically conductive when the first condition does not exist at the first location and (b) a second-condition-sensitive member which is at the second location, which is electrically conductive when the second condition exists at the second location and is not electrically conductive when the second condition does not exist at the second location, and which is electrically connected in parallel with the first-condition-sensitive member.

(I) It is also possible, as shown for example in Figure 17, for the system to include two or more source members, which become respectively connected to the locating member when a particular condition (different for each source member) exists. In this case the event is the existence of one of those two (or more) conditions at any point along the elongate path followed by the locating and source members. The system can also include switches, e.g. as shown in Figure 17, such that it is possible to disconnect all but one of the source members, and thus to determine which of the particular conditions exists.

(J) It is also possible, as shown for example in Figure 18, for the system to include at least one auxiliary source member which is connected to the power source and which becomes connected to the source member (or to another auxiliary source member) when a particular second condition exists, the second condition being different from the first condition which causes the source member to become connected to the locating member. In this case, the event is the existence, at any one or more points along the path, of a second condition which causes the auxiliary source member to become connected to the source member, and the existence, at one or more points along the path, of a first condition which causes the source and locating members to become connected.

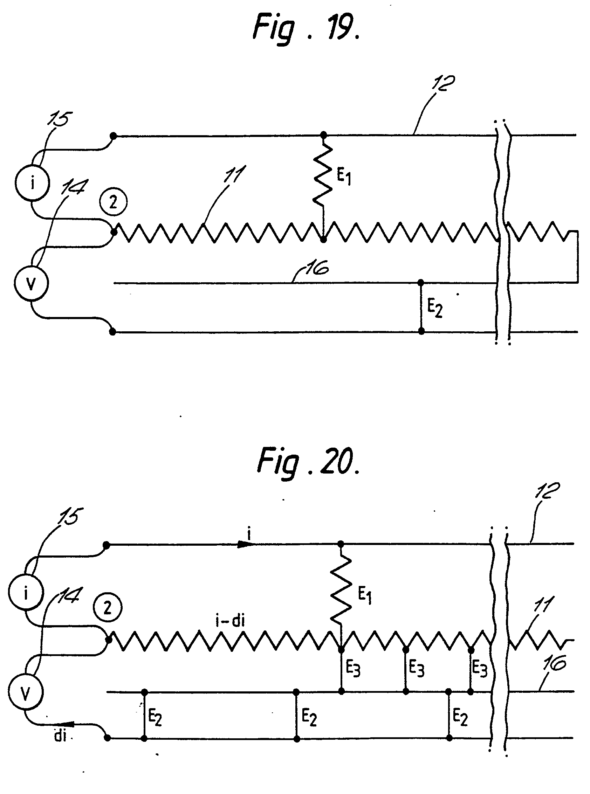

(K) It is also possible, as shown for example in Figures 19 and 20, for the system to include at least one auxiliary return member which is connected to the voltage-measuring device and which becomes connected to the return member when a second condition exists, the second condition being different from the first condition which causes the source and locating members to become connected. The return member can be connected to the end of the locating member which is remote from the second point, as illustrated in Figure 19, in which case the event is the existence of the first condition at one or more points along the path and the existence of the second condition at one or more points along the path, with the information provided being the location of the first condition which is nearest to the second point.

Alternatively, as illustrated in Figure 20, the return member can become connected to the locating member as the result of a third condition.

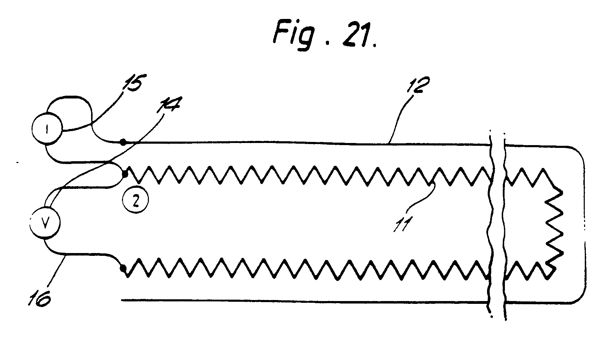

(L) It is also possible, as shown for example in Figure 21, for the apparatus to follow an elongate path in the form of a loop, so that the return member need not follow the elongate path but can simply join, via the voltage-measuring device, the two ends of the locating member.

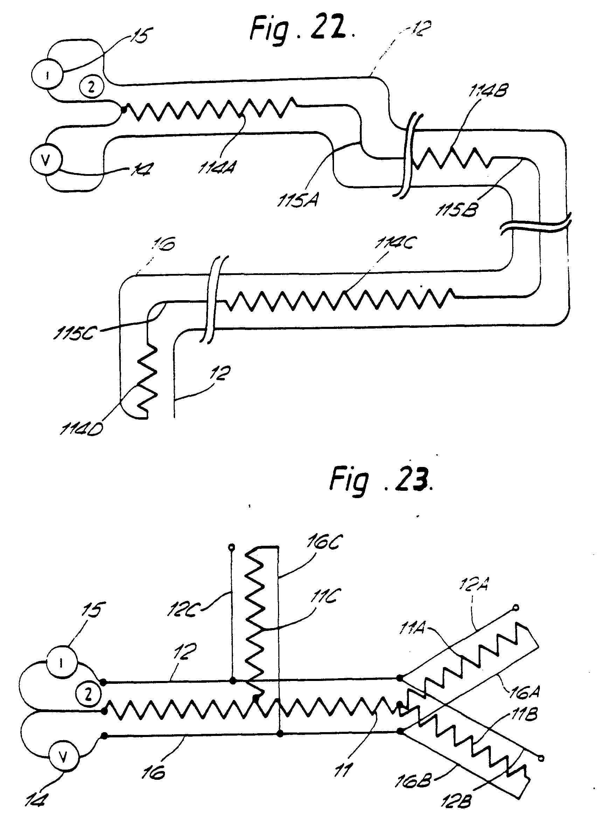

(M) It is also possible, as shown for example in Figure 22, when event-detection is required only in spaced apart zones, for the locating member to comprise:

(a) a plurality of spaced-apart elongate locating components (114A, 114B, 114C and 114D in Figure 22) which physically separate and electrically connect the locating components, which cannot become directly connected to the source member and which preferably have a relatively low resistance. This system might be used for example when detection and location was needed within each of a plurality of houses separated from each other along a street, but not between the houses.

(N) The method can also be used to locate events along a branched path, as illustrated in Figure 23. However, when using such a branched system, if the voltage-measuring device shows an event at a distance beyond the first branching point, then there are often two or more possible locations for the fault. If desired, the location can be precisely identified by connecting the controlled current source and voltmeter to the conductors at the branch point(s) (preferably *via* low resistance drop leads installed at the same time as the detection system). (This expedient can also be used in unbranched systems in order to provide improved accuracy of location of the event, after the general vicinity of the event has been indicated.) Alternatively, AC current sources of different frequencies can be employed sequentially and filters can be placed in the different branches so that only one branch is being tested at any one time. Of the event, after the general vicinity of the event has been indicated.) Alternatively, AC current sources of different frequencies can be employed sequentially and filters can be placed in the different branches so that only one branch is being tested at any one time.

(O) It is also possible, as shown for example in Figures 9 and 24—28, for the source member to have the same impedance characteristics as the locating member, and to be connected so that the only variable impedance in the test circuit is the impedance of the connection, Figures 9, 24, 25, 27 and 29 show the locating and source members as continuous resistors of constant resistance per unit length. Figure 26 shows the locating and source members comprising a plurality of resistors 111 (in the locating member) and 121 (in the source member), which can have the same or different resistances $R_l$ to $R_m$, and a plurality of low resistance intermediate components 112 and 122. The event connections E in Figures 24, 25, 27 and 28 are shown as resistors of indeterminate size. In Figure 26, the event connection is made by closing one or more of the switches S, which have in series with them resistors $R_A$ to $R_N$ which can be the same or different.

Figure 26 also shows a reference resistor $R_f$ connected in series with the locating member, and a voltmeter 141 which measures the voltage drop over the reference resistor, so that the location of the connection can be calculated from the ratio of the voltage drops measured by the two voltmeters.

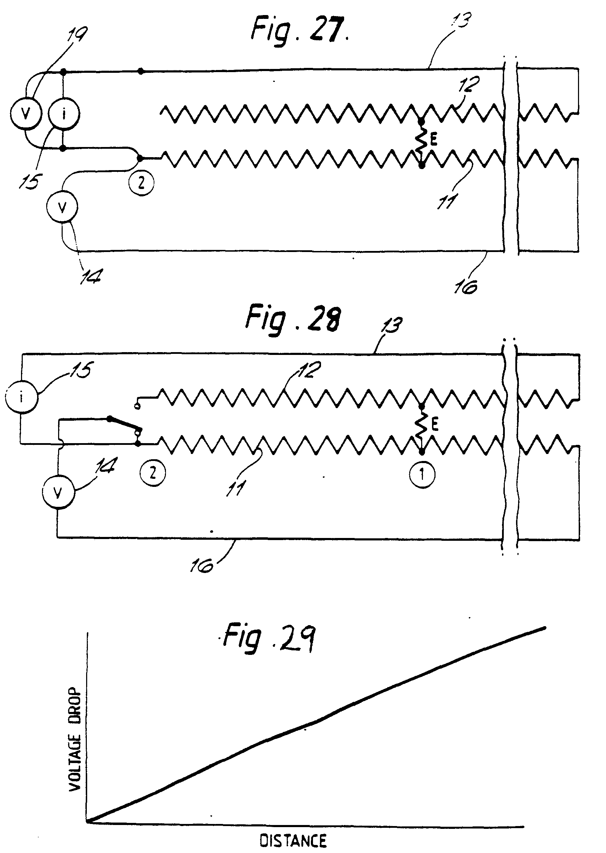

Figure 27 is the same as Figure 24 except that it also includes a second voltmeter 19 which measures the output voltage of the power source. The impedance of the connection E can be calculated from the output voltage (so. long as the power source is delivering the desired "fixed" current).

Figure 28 is somewhat similar to Figure 24, but incorporates a switch 161 such that the return member can be connected as shown (the system then being precisely as shown in Figure 24) or can be disconnected from the near end of the located member and connected to the near end of the source member. In the latter configuration, the voltage measured by the voltmeter is a measure of the impedance of the connection E.

(14) Voltage drop vs. distance

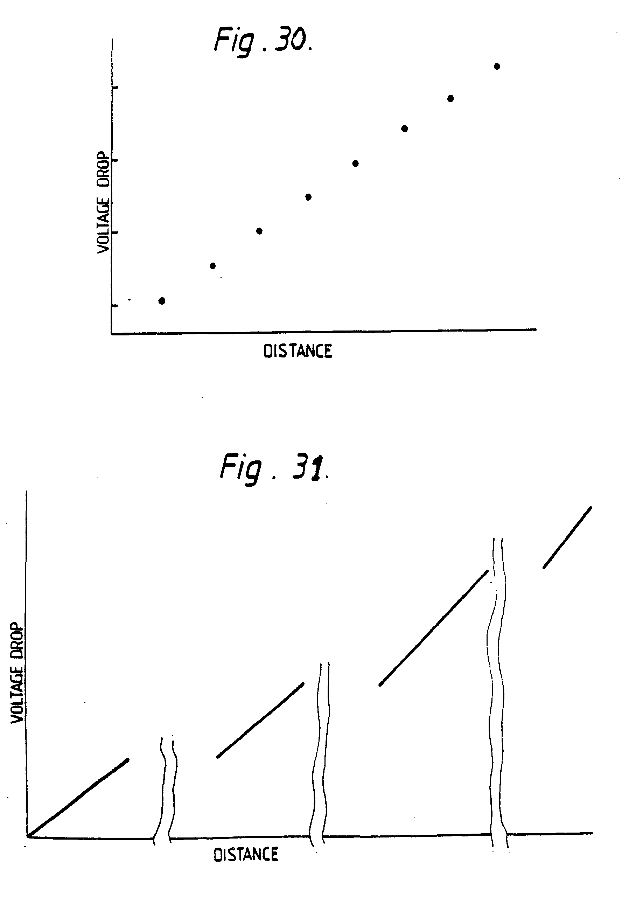

The relationship between the voltage drop measured by the voltage-measuring device and the distance between the first and second points will depend on the way in which the apparatus is designed. When connection can be made to the locating member at any point along its length, and the locating member is of uniform impedance along its length, then the relationship will be a straight line of uniform slope, as illustrated in Figure 29. When the event-sensitive connection means is discontinuous, so that connection to the locating member is possible only at spaced-apart point then the relationship will be a series of points as shown in Figure 30. When the locating member is divided into locating and connection zones and can be contacted at any point within a locating zone, as shown in Figure 22, then the relationship is as shown in Figure 31.

(15) Particular event-sensitive connection means

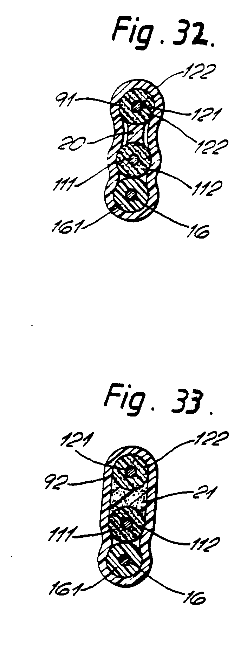

Figures 32 and 33 show cross-sections through apparatus of the invention. In Figures 32 and 33, the apparatus includes a source member having a metal core 121 and a conductive polymer coating 122; a locating member having a core 111 which is composed of a metal whose resistivity is substantially invariant with temperature and a conductive polymer coating 112; and a return member 16 which is composed of metal and is surrounded by a polymeric insulating jacket 161.

In Figure 32, a polymeric insulating connecting member 20 having concave surfaces lies between the source and locating members, and the components are joined together by an apertured, and therefore liquid-permeable, insulating jacket 91. So long as there is no electrolyte around the apparatus shown in Figure 32, there is no electrical connection between the locating and source members. However, if the apparatus is exposed to an electrolyte, an ionic connection is made between the locating and source members.

In Figure 33, a member 21 lies between the locating and source members, and the components are surrounded by an insulating jacket 92. Under normal conditions, the member 21 prevents electrical contact between the locating and source members, but the member 21 consists of or contains a material which becomes an electrical conductor when an event occurs. For example, the member 21 can comprise an organic polymer foam which is impregnated with a material which forms mobile ionic species when the foam structure is damaged, for example by an event involving excessive pressure transmitted through a flexible jacket 92, or an event involving excessive temperature which causes the foam to melt, or an event involving the presence of a chemical which can penetrate the jacket 92 (which may be apertured for this purpose) and which reacts with the foamed member. The member 21 can also be composed of a material which becomes conductive when it is compressed.

The invention is illustrated by the following Examples;

Example 1

A circuit as shown in Figure 2 was prepared. The controlled current source was a galvanostat with a compliance voltage of 18 volts and produced a controlled current of 0.001 amp. The voltmeter and an input impedance of 1 megohm and a full scale reading of 200 mV. The source member was a 30 AWG copper wire (diameter about 0.032 cm) which was surrounded by a melt-extruded jacket of a conductive polymer composition. The jacket was about 0.04 inch (0.1 cm) thick. The conductive polymer composition has a resistivity of about 3 ohm. cm at 25°C and comprised carbon black (about 45 parts by weight) dispersed in a thermoplastic rubber which is sold under the trade name TPR-5490 and which is believed to be a blend of polypropylene and an ethylene/propylene rubber (about 55 parts by weight). The locating member was the same as the first except that a 30 AWG Constantan wire (diameter about 0.032 cm) was used instead of the copper wire. The resitance of the second conductor was 2.940 ohms/foot (9.65 ohm/m). The return member was a 12 AWG copper wire (diameter about 0.28 cm) and it was surrounded by a polymeric insulating jacket.

In a number of tests, a damp sponge was placed on the locating and source members to effect electrical connection between them, the members being dried between the tests. It was found that, as expected from theory, the distance (d) in meters to the damp sponge could be calculated from the equation

$$d = \frac{V}{0.001 \times 9.65}$$

where V is the voltage (in volts) recorded by the voltmeter, the discrepancy between the actual and calculated values of d was less than 0.1%.

## Claims

1. A method for monitoring for the occurrence of an event, and for locating the event upon its occurrence, which method comprises providing a system in which, upon occurrence of the event,

(1) electrical connection is made between an electrically conductive locating member and an electrically conductive source member generally coextensive with the locating member;

the locating member and/or the source member comprising a metal core and an elongate jacket which electrically surrounds the core and which is composed of a conductive polymer, and which is event sensitive in such a manner as to allow said connection upon occurrence of an event;

the connection to the locating member being effective at a first point whose location is defined by at least one characteristic of the event;

the making of the connection enabling the formation of a test circuit which comprises (a) the source member, (b) the connection, (c) that part of the locating member which lies between the first point and a second point having a known location on the locating member, and (d) a power source which causes an electrical current of known size to be transmitted between the first and second points on the locating member; and

the current and the locating member being such that, by measuring the voltage drop between the first and second points, the spatial relationship between the first and second points can be determined;

(2) the voltage drop between the first and second points is measured; and

(3) information concerning the event is obtained from the measurement made in step (2).

2. A method according to claim 1 wherein

(a) the locating member and the source member are elongate; and

(b) the second point is a fixed point at one end of the locating member.

3. A method according to claim 1 or 2, wherein the power source is a controlled current source which delivers a known fixed current.

4. A method according to claim 3 wherein the controlled current source supplies a known current which is less than 10 milliamps.

5. A method according to any one of the preceding claims wherein the voltage drop between the first and second points is determined by means of a voltage-measuring device which forms part of a reference circuit, the reference circuit comprising

(a) the voltage-measuring device,

(b) that part of the locating member which lies between the first and second points, and

(c) an electrically conductive return member having a first end which is electrically connected to one end of the locating member via the voltage measuring device and a second end which is electrically connected to the other end of the locating member, the return member being otherwise insulated from the locating member, the voltage-measuring device having an impedance which is very high by comparison with the impedance of the other components of the reference circuit.

6. A method according to any one of the preceding claims which also comprises switching the components of the system from a first arrangement in which the second point is at one end of the locating member to a second arrangement in which the second point is at the opposite end of the locating member.

7. A method according to any one of the preceding claims wherein the connection between the locating member and the source member has a substantial and unknown impedance.

8. A method according to any one of the preceding claims wherein information concerning the event is obtained in step (3) only when the ratio V/I is within a predetermined range, wherein V is the output voltage of the power source and I is the current in the test circuit.

9. A method according to claim 8 wherein the power source is a controlled current source which delivers current at a fixed value, and information is obtained in step (3) only when the current between the first and second points is substantially at said fixed value.

10. A method according to any one of the preceding claims wherein
(a) the locating member has a total impedance $Z_{total}$; and
the connection to the locating member being effective at a first point whose location is defined by at least one characteristic of the event;
(b) the test circuit also includes a component which
(i) is connected in series with that part of the locating member between the first point and a second point, and
(ii) has an impedance substantially equal to the difference between $Z_{total}$ and the impedance of that part of the locating member between the first point and the second point.

11. A method according to claim 10 wherein the source member has substantially the same impedance characteristics as the locating member, and said component is a part of the source member.

12. A method according to claim 10 or 11 which also comprises measuring the impedance of the connection between the locating and source members.

13. A method according to any one of the preceding claims wherein the locating member comprises (1) a plurality of spaced-apart locating zones, each of said zones providing a series of points to which the connection can be made, and (2) a plurality of spaced-apart connection zones which physically separate and electrically connect the locating zones and which cannot become connected to the source member.

14. A method according to any one of the preceding claims wherein the locating member has a temperature coefficient of impedance which averages less than 0.003 per degree C over the temperature range 0 to 100°C.

15. A method according to any one of the preceding claims wherein the locating member comprises:
(A) an elongate core which is composed of a metal whose temperature coefficient of resistivity averages less than 0.003 per degree C over the temperature range 0° to 100°C and in which each longitudinal section has a resistance from $10^{-4}$ to $10^4$ ohms/foot ($3.3 \times 10^{-4}$—$3.3 \times 10^4$ ohm/m); and
(B) an elongate jacket which is composed of a conductive polymer, which electrically surrounds the core and in which each longitudinal section has a resistance which is at least 100 times the resistance of the core of that longitudinal section at all temperatures from 0° to 100°C.

16. A method according to any one of the preceding claims wherein the event is the presence of sufficient electrolyte to connect the locating and source members.

17. A method according to claim 1 wherein the event is a change in the concentration of a particular substance, and the locating and source members are physically contacted by a connecting member which insulates them from each other prior to said change and which effects or permits electrical connection between the locating member and the source member as a result of said change.

18. A method according to claim 1 wherein event-monitoring is required only in spaced-apart zones, and the locating members comprises (a) a plurality of spaced-apart locating components which are in said zones and to which connection is
made upon occurrence of an event, and (b) a plurality of spaced-apart intermediate components which physically separate and electrically connect the locating components and which cannot become directly connected to the source member.

19. Apparatus suitable for use in the method claimed in any one of claims 1 to 18, which apparatus comprises
(1) an elongate electrically conductive locating member whose impedance from one end to any point thereon defines the spatial relationship between that end and that point;
(2) an elongate electrically conductive source member generally coextensive with the locating member;
the locating member and/or the source member comprising a metal core (111, 121) and an elongate jacket (112, 122) which electrically surrounds the core and which is composed of a conductive polymer;
(3) an event-sensitive connection means which,

upon occurrence of an event, effects electrical connection between the locating member and the source member, the connection being effective at a first point on the locating member which is defined by at least one characteristic of the event;

(4) a voltage-measuring device for determining the voltage drop between the first point and a second point which is at one end of the locating member;

(5) a power source which will furnish a current of known size, and which is electrically connected to the second point on the locating member and, in the absence of an event, is not otherwise connected to the locating member; and

(6) a return member (16) having a first end which is electrically connected to one end of the locating member via the voltage-measuring device and a second end which is electrically connected to the other end of the locating member, the return member being otherwise insulated from the locating member;

whereby upon occurrence of an event which causes an electrical connection between the locating and source members, this enables the formation of the test circuit and a reference circuit which comprises the voltage-measuring device, the locating member, and the return member, the voltage-measuring device having an impedance which is very high by comparison with the impedance of the other components of the reference circuit.

20. Apparatus according to claim 19 wherein the power source is a controlled current source which, when an event occurs, supplies a known fixed current.

21. Apparatus according to claim 19 or 20 which includes means for preventing the display of information about the event if the value of the ratio V/I is outside a predetermined range, wherein V is the output voltage of the power source in volts and I is the current in the test circuit in amps.

22. Apparatus according to any of claims 19 to 21 wherein the source member has the same impedance characteristics as the locating member.

23. Apparatus according to any of claims 19 to 22, wherein the locating member comprises:

(A) an elongate core which is composed of a metal whose temperature coefficient of resistivity averages less than 0.003 per degree Centigrade over the temperature range 0° to 100°C and in which each longitudinal section has a resistance which is from $10^{-4}$ to $10^4$ ohms/foot $(3.3 \times 10^{-4}$—$3.3 \times 10^4$ ohm/m), and

(B) an elongate jacket which is composed of a conductive polymer, which electrically surrounds the core, and in which each longitudinal section has a resistance which is at least 100 times the resistance of the core of that longitudinal section at all temperatures from 0° to 100°C.

24. An apparatus according to claim 23, in which the core has a resistance of 1 to 20 ohm/foot (3.3 to 65 ohm/metre) and a temperature coefficient of resistance which averages less than 0.0003 per degree Centigrade in the temperature range 0° to 100°C.

**Patentansprüche**

1. Verfahren zum Überwachen des Auftretens eines Ereignisses und zum Lokalisieren dieses Ereignisses bei Auftreten, welches die Bereitstellung eines Systems umfaßt, in dem bei Auftreten des Ereignisses

(1) eine elektrische Verbindung zwischen einem elektrisch leitfähigen Ortungselement und einem elektrisch leitfähigen Quellenelement, welches im allgemeinen die gleiche Ausdehnung wie das Ortungselement hat, hergestellt wird;

wobei das Ortungselement und/oder das Quellenelement einen Metallkern und ein langgestrecktes Gehäuse aufweisen, welches den Kern elektrisch umgibt und welches aus einem leitfähigen Polymeren zusammengesetzt ist und welches derart ereignisempfindlich ist, daß es die Verbindung bei Auftreten eines Ereignisses zustandekommen läßt;

wobei die Verbindung zum Ortungselement an einem ersten ·Punkt, dessen Lage durch wenigstens ein Merkmal des Ereignisses bestimmt ist, wirksam ist;

wobei die Herstellung der Verbindung die Bildung eines Testkreises ermöglich, welcher enthält: (a) das Quellenelement, (b) die Verbindung, (c) den Teil des Ortungselements, welcher zwischen dem ersten Punkt und einem zweiten Punkt mit bekannter Lage auf dem Ortungselement liegt und (d) eine Energiequelle, die verursacht, daß· elektrischer Strom von bekannter Größe zwischen dem ersten und zweiten Punkt auf dem Ortungselement geleitet wird; und

wobei der Strom und das Ortungselement derart sind, daß durch Messung des Spannungsabfalls zwischen dem ersten und dem zweiten Punkt die räumliche Beziehung zwischen erstem und zweitem Punkt bestimmt werden kann;

(2) der Spannungsabfall zwischen dem ersten und dem zweiten Punkt gemessen wird; und

(3) die Information über das Ereignis durch die Messung aus Schritt (2) erhalten wird.

2. Verfahren nach Anspruch 1, bei dem

(a) das Ortungselement und das Quellenelement langgestreckt sind; und

(b) der zweite Punkt ein fester Punkt an einem Ende des Ortungselements ist.

3. Verfahren nach Anspruch 1 oder 2, bei dem die Energiequelle eine geregelte Stromquelle ist, die einen bekannten, festgelegten Strom liefert.

4. Verfahren nach Anspruch 3, bei dem die geregelte Stromquelle einen bekannten Strom unter 10 Milliampere liefert.

5. Verfahren nach einem der vorangehenden Ansprüche, bei dem der Spannungsabfall zwischen dem ersten und dem zweiten Punkt durch eine Spannungsmeßvorrichtung, die Teil des Bezugsstromkreises ist, bestimmt wird, wobei der Bezugsstromkreis enthält

(a) die Spannungsmeßvorrichtung

(b) den Teil des Ortungselements, welches

zwischen dem ersten und dem zweiten Punkt liegt, und

(c) ein elektrisch leitfähiges Rückführungselement mit einem ersten Ende, welches über die Spannungsmeßvorrichtung mit einem Ende des Ortungselements elektrisch verbunden ist, und einem zweiten Ende, welches mit dem anderen Ende des Ortungselements elektrisch verbunden ist, wobei das Rückführungselement ansonsten von dem Ortungselement isoliert ist und die Spannungsmeßvorrichtung eine Impedanz aufweist, die im Vergleich zu der Impedanz der anderen Komponenten des Bezugsstromkreises, sehr hoch ist.

6. Verfahren nach einem der vorangehenden Ansprüche, das auch das Schalten der Systemkomponenten von einer ersten Anordnung, bei der sich der zweite Punkt an einem Ende des Ortungselements befindet, zu einer zweiten Anordnung umfaßt, bei der sich der zweite Punkt auf der gegenüberliegenden Seite auf dem Ortungselement befindet.

7. Verfahren nach einem der vorangehenden Ansprüche, bei dem die Verbindung zwischen dem Ortungselement und dem Quellenelement eine erhebliche und unbekannte Impedanz aufweist.

8. Verfahren nach einem der vorangehenden Ansprüche, bei dem die Information über das Ereignis nur dann durch Schritt (3) erhalten wird, wenn das Verhältnis V/I innerhalb eines vorbestimmten Bereichs liegt, wobei V die Ausgangsspannung der Energiequelle und I der Strom in dem Testkreis ist.

9. Verfahren nach Anspruch 8, bei dem die Energiequelle eine geregelte Stromquelle ist, welche Strom zu einem bestimmten Wert liefert, und bei dem die Information in Schritt (3) nur dann erhalten wird, wenn der Strom zwischen dem ersten und zweiten Punkt im wesentlichen diesen genannten, festgelegten Wert hat.

10. Verfahren nach einem der vorangehenden Ansprüche, bei dem

(a) das Ortungselement eine Gesamtimpedanz $Z_{total}$ hat und

die Verbindung zum Ortungselement an einem ersten Punkt wirksam wird, dessen Lage durch wenigstens ein Merkmal des Ereignisses bestimmt wird,

(b) der Testkreis auch eine Komponente enthält, die

(i) in Reihe mit dem Teil des Ortungselements geschaltet ist, das zwischen dem ersten und einem zweiten Punkt liegt, und

(ii) eine Impedanz aufweist, die im wesentlichen gleich der Differenz zwischen $Z_{total}$ und der Impedanz des Teils des Ortungselements zwischen dem ersten und dem zweiten Punkt ist.

11. Verfahren nach Anspruch 10, bei dem das Quellenelement im wesentlichen die gleichen Impedanzmerkmale aufweist wie das Ortungselement, und bei dem die oben erwähnte Komponente Teil des Quellenelements ist.

12. Verfahren nach Anspruch 10 oder 11, das auch die Messung der Impedanz der Verbindung zwischen Ortungs- und Quellenelement umfaßt.

13. Verfahren nach einem der vorangehenden Ansprüche, bei dem das Ortungselement enthält: (1) eine Vielzahl von im Abstand voneinander angeordneten Ortungszonen, wobei jede dieser Zonen eine Reihe von Punkten, an denen die Verbindung vorgenommen werden kann, aufweist und (2) eine Vielzahl von im Abstand voneinander angeordneten Verbindungszonen, die die Ortungszonen physikalisch trennen und elektrisch verbinden und welche nicht mit dem Quellenelement verbunden werden können.

14. Verfahren nach einem der vorangehenden Ansprüche, bei dem das Ortungselement einen Temperaturkoeffizienten der Impedanz aufweist, der im Durchschnitt weniger als 0,003 pro Grad Celsius über den Temperaturbereich von 0 bis 100°C beträgt.

15. Verfahren nach einem der vorangehenden Ansprüche, bei dem das Ortungselement umfaßt:

(A) einen langgestreckten Kern, der aus einem Metall besteht, dessen Temperaturkoeffizient des spezifischen Widerstandes im Durchschnitt weniger als 0,003 pro Grad Celsius über den Temperaturbereich von 0° bis 100°C beträgt und bei dem jeder langgestreckte Abschnitt einen Widerstand von $10^{-4}$ bis $10^4$ Ohm/Fuß ($3,3 \times 10^{-4}$—$3,3 \times 10^4$ Ohm/m) hat und

(B) ein langgestrecktes Gehäuse, das aus einem leitfähigen Polymeren besteht, den Kern elektrisch umgibt und bei dem jeder Längsabschnitt einen Widerstand aufweist, der bei allen Temperaturen von 0° bis 100°C wenigstens 100 mal so groß wie der Widerstand des Kerns dieses Längsabschnitts ist.

16. Verfahren nach einem der vorangehenden Ansprüche, bei dem das Ereignis die Anwesenheit von ausreichend Elektrolyten ist, um das Ortungs- und das Quellenelement zu verbinden.

17. Verfahren nach Anspruch 1, bei dem das Ereignis die Konzentrationsänderung einer bestimmten Substanz ist, und das Ortungs- und das Quellenelement physikalisch durch ein Verbindungteil, welches sie vor dieser Änderung voneinander isoliert, in Kontakt gebracht werden, und welches bewirkt oder gestattet, daß die elektrische Verbindung zwischen Ortungselement und Quellenelement als Ergebnis dieser Änderung zustandekommt.

18. Verfahren nach Anspruch 1, bei dem die Ereignisüberwachung nur in im Abstand voneinander angeordneten Zonen erforderlich ist, und bei dem das Ortungselement enthält: (a) eine Vielzahl von im Abstand voneinander angeordneten Ortungskomponenten, die sich in den erwähnten Zonen befinden und zu welchen die Verbindung bei Auftreten eines Ereignisses hergestellt wird, und (b) eine Vielzahl von im Abstand voneinander angeordneten Zwischenkomponenten, die die Ortungskomponenten physikalisch trennen und elektrisch verbinden, und die nicht direkt mit dem Quellenelement verbunden werden können.

19. Vorrichtung zur Durchführung des Verfahrens nach einem der Ansprüche 1 bis 18, enthaltend:

(1) ein langgestrecktes elektrisch leitfähiges Ortungselement, dessen Impedanz von einem Ende zu irgendeinem Punkt darauf die räumliche Beziehung zwischen diesem Ende und diesem Punkt bestimmt;

(2) ein langgestrecktes elektrisch leitfähiges Quellenelement, das im allgemeinen die gleiche Ausdehnung wie das Ortungselement hat;

wobei das Ortungselement und/oder das Quellenelement einen Metallkern (111, 121) und ein langgestrecktes Gehäuse (112, 122) enthält, welches den Kern elektrisch umgibt und aus einem leitfähigen Polymer besteht;

(3) ein ereignisempfindliches Verbindungsteil, welches bei Auftreten des Ereignisses die elektrische Verbindung zwischen dem Ortungselement und dem Quellenelement bewirkt, wobei die Verbindung wirksam wird an einem ersten Punkt auf dem Ortungselement, der durch wenigstens ein Merkmal des Ereignisses bestimmt ist;

(4) eine Spannungsmeßvorrichtung zur Bestimmung des Spannungsabfalls zwischen dem ersten Punkt und einem zweiten Punkt, welcher sich an einem Ende des Ortungselements befindet;

(5) eine Energiequelle, die Strom von bekannter Größe liefert, und die elektrisch mit dem zweiten Punkt auf dem Ortungselement verbunden ist, und, die bei Abwesenheit eines Ereignisses, nicht anderweitig mit dem Ortungselement verbunden ist; und

(6) ein Rückführungselement (16) mit einem ersten Ende, das elektrisch mit einem Ende des Ortungselements über die Spannungsmeßvorrichtung verbunden ist, und einem zweiten Ende, das elektrisch mit dem anderen Ende des Ortungselements verbunden ist, wobei das Rückführungselement ansonsten von dem Ortungselement isoliert ist;

wobei bei Auftreten eines Ereignisses, des eine elektrische Verbindung zwischen Ortungs- und Quellenelement verursacht, diese die Bildung eines Testkreises und eines Bezugskreises ermöglicht, wobei der Bezugskreis die Spannungsmeßvorrichtung, das Ortungselement und das Rückführungselement enthält, wobei die Spannungsmeßvorrichtung eine Impedanz aufweist, die im Vergleich mit der Impedanz der anderen Komponenten des Bezugskreises sehr hoch ist.

20. Vorrichtung nach Anspruch 19, bei der die Energiequelle eine geregelte Stromquelle ist, die bei Auftreten des Ereignisses einen bekannten und festgelegten Strom liefert.

21. Vorrichtung nach Anspruch 19 oder 20, welche Einrichtungen enthält, die verhindern, daß die Informationen über ein Ereignis wiedergegeben werden, wenn der Wert des Verhältnisses V/I außerhalb eines vorbestimmten Bereichs liegt, wobei V die Ausgangsspannung der Energiequelle in Volt und I der Strom im Testkreis in Ampere bedeuten.

22. Vorrichtung nach einem der Ansprüche 19 bis 21, bei der das Quellenelement die gleichen Impedanzmerkmale wie das Ortungselement aufweist.

23. Verfahren nach einem der Ansprüche 19 bis 22, bei der das Ortungselement enthält:

(A) einen langgestreckten Kern, der aus einem Metall besteht, dessen Temperaturkoeffizient des spezifischen Widerstandes im Durchschnitt weniger als 0,003 pro Grad Celsius über den Temperaturbereich von 0 bis 100°C beträgt und bei dem jeder Längsabschnitt einen Widerstand von $10^{-4}$ bis $10^4$ Ohm/Fuß ($3,3 \times 10^{-4}$—$3,3 \times 10^4$ Ohm/m) aufweist und

(B) ein langgestrecktes Gehäuse, das aus einem leitfähigen Polymeren besteht, den Kern elektrisch umgibt und bei dem jeder Längsabschnitt einen Widerstand aufweist, der im gesamten Temperaturbereich von 0 bis 100°C wenigstens 100 mal so groß wie der Widerstand des Kerns dieses Längsabschnitts ist.

24. Vorrichtung nach Anspruch 23, bei der der Kern einen Widerstand von 1 bis 20 Ohm/Fuß (3,3 bis 65 Ohm/m) und einen Temperaturkoeffizienten des Widerstandes aufweist, welcher im Durchschnitt weniger als 0,0003 pro Grad Celsius im Temperaturbereich von 0° bis 100°C beträgt.

**Revendications**

1. Procédé pour contrôler l'apparition d'un événement et pour localiser l'événement à son apparition, lequel procédé consiste à utiliser un système dans lequel, à l'apparition de l'événement,

(1) une connexion électrique est établie entre un élément de localisation électriquement conducteur et un élément source électriquement conducteur, globalement de même étendue que l'élément de localisation;

l'élément de localisation et/ou l'élément source comprenant une âme métallique et une gaine allongée qui entoure électriquement l'âme et qui est composée d'un polymère conducteur, et qui est sensible à un événement de manière à permettre ladite connexion lors de l'apparition d'un événement;

la connexion sur l'élément de localisation étant effectuée en un premier point dont l'emplacement est défini par au moins une caractéristique de l'événement;

la réalisation de la connexion permettant la formation d'un circuit d'essai qui comprend (a) l'élément source, (b) la connexion, (c) la partie de l'élément de localisation qui s'étend entre le premier point et un second point ayant un emplacement connu sur l'élément de localisation, et (d) une source d'énergie qui provoque la transmission d'un courant électrique de valeur connue entre les premier et second points sur l'élément de localisation; et

le courant et l'élément de localisation étant tels que, en mesurant la chute de tension entre les premier et second points, on peut déterminer la relation spatiale entre les premier et second points;

(2) la chute de tension entre les premier et second points est mesurée; et

(3) une information concernant l'événement est obtenue d'après la mesure effectuée à l'étape (2).

2. Procédé selon la revendication 1, dans lequel

(a) l'élément de localisation et l'élément source sont allongés; et

(b) le second point est un point fixe à une extrémité de l'élément de localisation.

3. Procédé selon la revendication 1 ou 2, dans lequel la source d'énergie est une source de courant régulé qui fournit un courant fixé connu.

4. Procédé selon la revendication 3, dans lequel la source de courant régulé fournit un courant connu qui est inférieur à 10 milliampères.

5. Procédé selon l'une quelconque des revendications précédentes, dans lequel la chute de tension entre les premier et second points est déterminée au moyen d'un dispositif de mesure de tension qui fait partie d'un circuit de référence, le circuit de référence comprenant

(a) le dispositif de mesure de tension,

(b) la partie de l'élément de localisation qui s'étend entre les premier et second points, et

(c) un élément de retour, électriquement conducteur, ayant une extrémité qui est connectée électriquement à une extrémité de l'élément de localisation par l'intermédiaire du dispositif de mesure de tension et une seconde extrémité qui est connectée électriquement à l'autre extrémité de l'élément de localisation, l'élément de retour étant autrement isolé de l'élément de localisation, le dispositif de mesure de tension ayant une impédance qui est très élevée en comparaison avec l'impédance des autres composants du circuit de référence.

6. Procédé selon l'une quelconque des revendications précédentes, qui consiste aussi à commuter les composants du système d'un premier agencement, dans lequel le second point se trouve à une extrémité de l'élément de localisation, à un second agencement dans lequel le second point se trouve à l'extrémité opposée de l'élément de localisation.

7. Procédé selon l'une quelconque des revendications précédentes, dans lequel la connexion entre l'élément de localisation et l'élément source présente une impédance importante et inconnue.

8. Procédé selon l'une quelconque des revendications précédentes, dans lequel une information concernant l'événement est obtenue à l'étape (3) uniquement lorsque le rapport V/I est compris dans une gamme prédéterminée, où V est la tension de sortie de la source d'énergie et I est le courant dans le circuit d'essai.

9. Procédé selon la revendication 8, dans lequel la source d'énergie est une source de courant régulée qui fournit un courant à une valeur fixée, et une information est obtenue à l'étape (3) uniquement lorsque le courant entre les premier et second points est sensiblement à ladite valeur fixée.

10. Procédé selon l'une quelconque des revendications précédentes, dans lequel

(a) l'élément de localisation présente une impédance totale $Z_{total}$; et

la connexion sur l'élément de localisation étant effective en un premier point dont l'emplacement est défini par au moins une caractéristique de l'événement;

(b) le circuit d'essai comprend aussi un composant qui

(i) est connecté en série avec la partie de l'élément de localisation située entre le premier point et un second point, et

(ii) présente une impédance sensiblement égale à la différence entre $Z_{total}$ et l'impédance de la partie de l'élément de localisation située entre le premier point et le second point.

11. Procédé selon la revendication 10, dans lequel l'élément source présente sensiblement les mêmes caractéristiques d'impédance que l'élément de localisation, et ledit composant est une partie de l'élément source.

12. Procédé selon la revendication 10 ou 11, qui consiste aussi à mesurer l'impédance de la connexion entre l'élément de localisation et l'élément source.

13. Procédé selon l'une quelconque des revendications précédentes, dans lequel l'élément de localisation comprend (1) plusieurs zones espacées de localisation, chacune desdites zones présentant une série de points sur lesquels la connexion peut être réalisée, et (2) plusieurs zones de connexion espacées qui séparent physiquement et connectent électriquement les zones de localisation et qui ne peuvent pas être connectées à l'élément source.

14. Procédé selon l'une quelconque des revendications précédentes, dans lequel l'élément de localisation possède un coefficient de température d'impédance qui, en moyenne, est inférieur à 0,003 par degré C sur la gamme de températures de 0 à 100°C.

15. Procédé selon l'une quelconque des revendications précédentes, dans lequel l'élément de localisation comprend:

(A) une âme allongée qui est composée d'un métal dont le coefficient de température de la résistivité est, en moyenne, inférieur à 0,003 par degré C sur la gamme de températures de 0° à 100°C et dans lequel chaque tronçon longitudinal possède une résistance de $10^{-4}$ à $10^4$ ohms/foot ($3,3 \times 10^{-4}$—$3,3 \times 10^4$ ohms/m); et

(B) une gaine allongée qui est composée d'un polymère conducteur, qui entoure électriquement l'âme et dans laquelle chaque tronçon longitudinal possède une résistance qui est d'au moins 100 fois la résistance de l'âme de ce tronçon longitudinal à toutes les températures de 0° à 100°C.

16. Procédé selon l'une quelconque des revendications précédentes, dans lequel l'événement est la présence de suffisamment d'électrolyte pour connecter l'élément de localisation et l'élément source.

17. Procédé selon la revendication 1, dans lequel l'événement est un changement de la concentration d'une substance particulière, et l'élément de localisation et l'élément source sont touchés physiquement par un élément de connexion qui les isole l'un de l'autre avant ledit changement et qui réalise ou permet une connexion électrique entre l'élément de localisation et l'élément source par suite dudit changement.

18. Procédé selon la revendication 1, dans lequel le contrôle d'un événement est demandé uniquement dans des zones espacées, et l'élément de localisation comprend (a) plusieurs composants espacés de localisation qui sont dans lesdites zones et sur lesquels une connexion est réalisée à l'apparition d'un événement, et (b) plusieurs composants intermédiaires espacés qui séparent physiquement et connectent électriquement les composants de localisation et qui ne peuvent pas se connecter directement sur l'élément source.

19. Appareil convenant à une utilisation dans le procédé selon l'une quelconque des revendications 1 à 18, lequel appareil comprend

(1) un élément allongé de localisation, électriquement conducteur, dont l'impédance d'une extrémité à un point quelconque de cet élément définit la relation spatiale entre cette extrémité et ce point;

(2) un élément source allongé, électriquement conducteur, globalement de même étendue que l'élément de localisation; l'élément de localisation et/ou l'élément source comprenant une âme métallique (111, 121) et une gaine allongée (112, 122) qui entoure électriquement l'âme et qui est composée d'un polymère conducteur;

(3) un moyen de connexion sensible à un événement qui, à l'apparition d'un événement, établit une connexion électrique entre l'élément de localisation et l'élément source, la connexion étant effective en un premier point sur l'élément de localisation qui est défini par au moins une caractéristique de l'événement;

(4) un dispositif de mesure de tension destiné à déterminer la chute de tension entre le premier point et un second point qui est à une extrémité de l'élément de localisation;

(5) une source d'énergie qui fournit un courant de valeur connue et qui est connectée électriquement au second point de l'élément de localisation et, en l'absence d'un événement, qui n'est autrement pas connectée à l'élément de localisation; et

(6) un élément de retour (16) ayant une première extrémité qui est connectée électriquement à une extrémité de l'élément de localisation par l'intermédiaire du dispositif de mesure de tension et une seconde extrémité qui est connectée électriquement à l'autre extrémité de l'élément de localisation, l'élément de retour étant autrement isolé de l'élément de localisation;

de manière qu'à l'apparition d'un événement qui provoque une connexion électrique entre l'élément de localisation et l'élément source, cei permette la formation du circuit d'essai et d'un circuit de référence qui comprend le dispositif de mesure de tension, l'élément de localisation et l'élément de retour, le dispositif de mesure de tension ayant une impédance qui est très élevée en comparaison avec l'impédance des autres composants du circuit de référence.

20. Appareil selon la revendication 19, dans lequel la source d'énergie est une source de courant régulée qui, lorsqu'un événement apparaît, fournit un courant fixé connu.

21. Appareil selon la revendication 19 ou 20, qui comprend des moyens destinés à empêcher l'affichage d'une information concernant l'événement si la valeur du rapport V/I est extérieure à une gamme prédéterminée, où V est la tension de sortie de la source d'énergie, en volts, et I est le courant dans le circuit d'essai, en ampères.

22. Appareil selon l'une quelconque des revendications 19 à 21, dans lequel l'élément source possède les mêmes caractéristiques d'impédance que l'élément de localisation.

23. Appareil selon l'une quelconque des revendications 19 à 22, dans lequel l'élément de localisation comprend:

(A) une âme allongée qui est composée d'un métal dont le coefficient de température de la résistivité est, en moyenne, inférieur à 0,003 par degré Centigrade sur la gamme de températures de 0° à 100°C et dans laquelle chaque tronçon longitudinal posséde une résistance qui est comprise entre $10^{-4}$ et $10^4$ ohms/foot ($3,3 \times 10^{-4}$—$3,3 \times 10^4$ ohms/m), et

(B) une gaine allongée qui est composée d'un polymère conducteur, qui entoure électriquement l'âme, et dans laquelle chaque tronçon longitudinal possède une résistance qui est d'au moins 100 fois la résistance de l'âme de ce tronçon longitudinal à toutes les températures de 0° à 100°C.

24. Appareil selon la revendication 23, dans lequel l'âme possède une résistance de 1 à 20 ohms/foot (3,3 à 65 ohms/mètre) et un coefficient de température de la résistance qui, en moyenne, est inférieur à 0,0003 par degré Centigrade dans la gamme de températures de 0° à 100°C.

# Fig . 1.

# Fig.2.

# Fig.3.

# Fig.4.

2

# Fig .5 .

# Fig.6 .

EP 0 133 748 B1

Fig .7.

Fig .8.

Fig .9.

4

Fig.10.

Fig. 11.

Fig.12.

## Fig . 13 .

## Fig . 14 .

## Fig . 15 .

EP 0 133 748 B1

Fig. 16.

Fig. 17.

Fig. 18.

7

## Fig . 19.

## Fig . 20.

# Fig . 21.

**Fig. 22.**

**Fig. 23.**

Fig. 24.

Fig. 25.

Fig. 26.

Fig. 27.

Fig. 28

Fig. 29

VOLTAGE DROP

DISTANCE

Fig. 30.

VOLTAGE DROP

DISTANCE

Fig. 31.

VOLTAGE DROP

DISTANCE

EP 0 133 748 B1

# Fig. 32.

# Fig. 33.

14